# FASCICULE DE BREVET EUROPEEN

(11) **EP 4 565 039 B1**
(45) Date de publication et mention de la délivrance du brevet: **03.06.2026**
(21) Numéro de dépôt: 24215623.0
(22) Date de dépôt: 27.11.2024
(51) Int. Cl.: H10H 29/14, H10H 29/01, H10H 29/80, H10H 29/85, H01L 25/16, H10H 20/00, H10H 20/01, H10H 20/819, H10H 20/825, H10H 20/831

(54) **DISPOSITIF OPTOÉLECTRONIQUE COMPRENANT DES DIODES À TROIS ÉLECTRODES ET SON PROCÉDÉ DE FABRICATION**
OPTOELEKTRONISCHE VORRICHTUNG MIT DREI-ELEKTRODEN-DIODEN UND VERFAHREN ZU DEREN HERSTELLUNG
OPTOELECTRONIC DEVICE COMPRISING DIODES WITH THREE ELECTRODES AND METHOD FOR MANUFACTURING THE SAME

(30) Priorité: 01.12.2023 FR 2313439
(43) Date de publication de la demande: 04.06.2025
(73) Titulaire: Commissariat à l'Energie Atomique et aux Energies Alternatives, 75015 Paris (FR)
(72) Inventeur: SIMON, Julia, 38054 GRENOBLE CEDEX 9 (FR); LE MAITRE, Patrick, 38054 GRENOBLE CEDEX 9 (FR)
(74) Mandataire: Cabinet Beaumont

(56) Documents cités:
- US-A1- 2020 052 151
- US-A1- 2022 320 367

## Description

### Domaine technique

La présente description concerne de façon générale le domaine des dispositifs optoélectroniques comprenant des diodes électroluminescentes (également appelées « DELs » ou « LEDs » pour « Light-Emitting Diodes » en anglais) utilisées par exemple pour la réalisation de tout dispositif émissif lumineux (écrans, projecteurs, murs d'images, etc.), et/ou des photodiodes.

### Technique antérieure

Le document US 2022/0320367 A1 décrit un dispositif optoélectronique comprenant au moins des première et deuxième diodes électroluminescentes comprenant chacune: une première portion semi-conductrice dopée de type p et une deuxième portion semi-conductrice dopée de type n; une zone active comprenant des multi-puits quantiques entre les première et deuxième portions semi-conductrices; une couche conductrice, servant en fonctionnement de grille électrique, recouvrant les parois latérales de la zone active et d'au moins une partie de la première portion semi-conductrice; et une couche isolante interposée entre les parois latérales de la zone active et d'au moins une partie de la couche conductrice. Le dispositif comprend des moyens de commande de la couche conductrice, servant de grille, de la première diode électroluminescente indépendamment de la couche conductrice, servant également de grille, de la deuxième diode électroluminescente.

Le document US 2020/0052151 A1 décrit une diode électroluminescente à puce retournée (appelée "flip chip LED" en anglais) et un dispositif d'affichage comprenant plusieurs de ces diodes électroluminescentes à puce retournée, ainsi qu'un procédé pour leur fabrication. La diode à puce retournée comprend: une couche électroluminescente; une couche semi-conductrice de type n stratifiée sur une partie inférieure de la couche électroluminescente; une couche semi-conductrice de type p stratifiée sur une partie supérieure de la couche électroluminescente; une première électrode qui est électriquement connectée à la couche semi-conductrice de type n par l'intermédiaire d'un premier trou de contact formé dans la LED; une deuxième électrode qui est électriquement connectée à la couche semi-conductrice de type p, et est électriquement isolée de la première électrode; une couche métallique disposée dans une première zone, dans une deuxième zone et dans une troisième zone; une troisième électrode qui est formée sur la couche métallique dans la troisième zone, qui est électriquement connectée à la couche métallique, et qui est électriquement isolée de la première électrode et de la deuxième électrode; et une pluralité de couches isolantes.

Le document EP 2 960 951 A1 décrit un dispositif optoélectronique de type LED ou photodiode comportant, en plus des deux électrodes reliées chacune à l'un des semi-conducteurs d'une jonction p-n, une troisième électrode réalisée sous forme de grille ou de contact Schottky. Cette troisième électrode permet, en générant un champ électrique latéral permettant d'augmenter l'EQE (efficacité quantique externe), de contourner la problématique de manque de porteurs de charge dans certains matériaux semi-conducteurs du fait d'une énergie d'activation trop élevée des dopants dans ces matériaux semi-conducteurs, comme par exemple dans les matériaux à grands gaps tels que le diamant ou les structures épitaxiées à base d'AlGaN utilisées notamment pour les LEDs émettant dans le domaine des UV. Lorsque le dispositif comporte plusieurs LEDs et/ou photodiodes, la troisième électrode des LEDs et/ou photodiodes est commune et distribuée pour l'ensemble de ces LEDs et/ou photodiodes, par exemple sous la forme de tranchées formées autour des jonctions p-n ou à travers les jonctions p-n des LEDs et/ou photodiodes.

Un inconvénient d'un tel dispositif optoélectronique est que la prise de contact électrique des électrodes demande un alignement très précis lorsque ce dispositif est réalisé avec de faibles dimensions. Il est possible de faciliter cette prise de contact en réalisant le dispositif avec des dimensions plus importantes, et donc au détriment de la compacité du dispositif.

Le document WO 2019/141948 A1 décrit un dispositif optoélectronique de type LED ou photodiode à trois électrodes dans lequel la troisième électrode est couplée électriquement à la cathode. Ainsi, la prise de contact électrique est facilitée du fait qu'il n'est plus nécessaire d'accéder électriquement à cette troisième électrode et à la cathode de manière séparée. Un inconvénient de cette solution est que cette architecture ne permet pas de commander les potentiels électriques appliqués sur les troisièmes électrodes indépendamment de ceux appliqués sur les cathodes. Résumé de l'invention

Il existe donc un besoin de proposer un dispositif optoélectronique comprenant des diodes à trois électrodes ne présentant pas les inconvénients des solutions existantes.

La présente invention pallie tout ou partie des inconvénients des solutions connues et propose un dispositif optoélectronique selon la revendication indépendante 1 en annexe comprenant au moins :
- une pluralité de diodes comportant chacune une partie d'un empilement d'au moins une première et une deuxième couches semi-conductrices dopées selon des types de conductivité opposés, une portion de la première couche semi-conductrice de chaque diode étant couplée électriquement à une première électrode disposée sous ladite portion de la première couche semi-conductrice ;
- des tranchées traversant l'empilement, séparant les diodes les unes des autres et depuis lesquelles des deuxièmes électrodes sont accessibles électriquement ;
- une couche électriquement conductrice disposée au moins contre des parois latérales des tranchées, isolée électriquement de l'empilement, couplée électriquement aux deuxièmes électrodes et qui est interrompue de telle manière que des parties de la couche électriquement conductrice disposées autour de chacune des diodes soient isolées électriquement vis-à-vis d'autres parties de la couche électriquement conductrice disposées autour des autres diodes ;
- des portions électriquement conductrices disposées dans les tranchées, isolées électriquement de la couche électriquement conductrice et couplées électriquement les unes aux autres et à au moins une troisième électrode;
et dans lequel des parois de fond des tranchées sont au moins en partie formées par les deuxièmes électrodes.

Selon un mode de réalisation particulier, la couche électriquement conductrice est interrompue au niveau de parois de fond des tranchées.

Selon un mode de réalisation particulier, les portions électriquement conductrices sont couplées électriquement aux portions de la deuxième couche semi-conductrice d'au moins une partie des diodes correspondant à des LEDs.

Selon un mode de réalisation particulier, les portions électriquement conductrices sont couplées électriquement aux portions de la deuxième couche semi-conductrice des LEDs par au moins une couche électriquement conductrice et optiquement transparente disposée sur l'empilement et sur les portions électriquement conductrices.

Selon un mode de réalisation particulier, la couche électriquement conductrice et optiquement transparente est isolée électriquement de la couche électriquement conductrice par des portions diélectriques disposées entre la couche électriquement conductrice et la couche électriquement conductrice et optiquement transparente.

Selon un mode de réalisation particulier, les portions électriquement conductrices sont isolées électriquement de la couche électriquement conductrice par au moins une première couche diélectrique disposée entre les portions électriquement conductrices et la couche électriquement conductrice.

Selon un mode de réalisation particulier, la troisième électrode est disposée au niveau d'un bord du dispositif optoélectronique.

Selon un mode de réalisation particulier :
- chaque première électrode est disposée entre deux deuxièmes électrodes auxquelles sont couplées électriquement les parties de la couche électriquement conductrice localisées autour de la diode dont la portion de la première couche semi-conductrice est couplée électriquement à ladite première électrode, et
- le dispositif optoélectronique comporte plusieurs troisièmes électrodes chacune couplée électriquement à l'une des portions électriquement conductrices et disposée entre deux deuxièmes électrodes chacune couplée électriquement à des parties de la couche électriquement conductrice localisées autour de diodes différentes.

Selon un mode de réalisation particulier, le dispositif comporte plusieurs troisièmes électrodes chacune couplée électriquement à l'une des portions électriquement conductrices, chacune des premières électrodes étant disposée entre une des deuxièmes électrodes et une des troisièmes électrodes, et chacune des troisièmes électrodes est disposée entre une des premières électrodes et une des deuxièmes électrodes.

Selon un mode de réalisation particulier, les parties de la couche électriquement conductrice disposées autour d'au moins une partie des diodes correspondant à des photodiodes sont couplées électriquement aux portions de la deuxième couche semi-conductrice des photodiodes.

Selon un mode de réalisation particulier, les parties de la couche électriquement conductrice disposées autour des photodiodes sont couplées électriquement aux portions de la deuxième couche semi-conductrice des photodiodes par au moins une couche électriquement conductrice et optiquement transparente disposée sur l'empilement et sur les parties de la couche électriquement conductrice disposées autour des photodiodes.

Selon un mode de réalisation particulier, le dispositif comporte en outre une deuxième couche diélectrique disposée entre la couche électriquement conductrice et l'empilement.

La présente invention propose également un procédé selon la revendication indépendante 13 en annexe de réalisation d'un dispositif optoélectronique, comportant au moins les étapes de :
- réalisation d'un empilement d'au moins une première et une deuxième couches semi-conductrices dopées selon des types de conductivité opposés ;
- réalisation de tranchées traversant l'empilement, séparant les unes des autres des diodes comportant chacune une partie de l'empilement et rendant accessibles des deuxièmes électrodes telles que des parois de fond des tranchées soient au moins en partie formées par les deuxièmes électrodes, une portion de la première couche semi-conductrice de chaque diode étant couplée électriquement à une première électrode disposée sous ladite portion de la première couche semi-conductrice ;
- réalisation d'une couche électriquement conductrice disposée au moins contre des parois latérales des tranchées, isolée électriquement de l'empilement, couplée électriquement aux deuxièmes électrodes et qui est interrompue telle que des parties de la couche électriquement conductrice disposées autour de chacune des diodes soient isolées électriquement vis-à-vis des parties de la couche électriquement conductrice localisées autour des autres diodes ;
- réalisation de portions électriquement conductrices disposées dans les tranchées, isolées électriquement de la couche électriquement conductrice et couplées électriquement les unes aux autres et à au moins une troisième électrode.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un exemple de dispositif optoélectronique selon un premier mode de réalisation ;
la figure 2, la figure 3, la figure 4, la figure 5, la figure 6, la figure 7, la figure 8 et la figure 9 représentent des étapes d'un procédé de réalisation d'un dispositif optoélectronique selon le premier mode de réalisation ;
la figure 10 représente un exemple de dispositif optoélectronique selon un deuxième mode de réalisation ;
la figure 11, la figure 12, la figure 13 et la figure 14 représentent des étapes d'un procédé de réalisation d'un dispositif optoélectronique selon le deuxième mode de réalisation ;
la figure 15 représente un exemple de dispositif optoélectronique selon une première variante de réalisation ; et
la figure 16 représente un exemple de dispositif optoélectronique selon une deuxième variante de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, différents éléments du dispositif (par exemple le circuit intégré de commande) et différentes étapes du procédé de réalisation du dispositif (dépôt, photolithographie, gravure, etc.) ne sont pas détaillés. L'homme du métier sera à même de réaliser de manière détaillée ces éléments et de mettre en œuvre ces étapes à partir de la description donnée ici.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", "sur", "sous", etc., ou à des qualificatifs d'orientation, tels que les termes "horizontal", "vertical", etc., il est fait référence, sauf précision contraire, à l'orientation des figures dans une position normale d'utilisation.

Sauf précision contraire, les expressions "environ", "approximativement", "sensiblement", et "de l'ordre de" signifient à 10 % près, de préférence à 5 % près.

Dans tout le document, le terme "diode" est utilisé pour désigner une diode électroluminescente ou une photodiode.

Dans tout le document, le terme « LED » désigne une LED ou une micro-LED.

Dans tout le document, le terme "couche" est utilisé pour désigner une couche comprenant un unique matériau ou plusieurs matériaux disposés les uns contre les autres, c'est-à-dire un empilement.

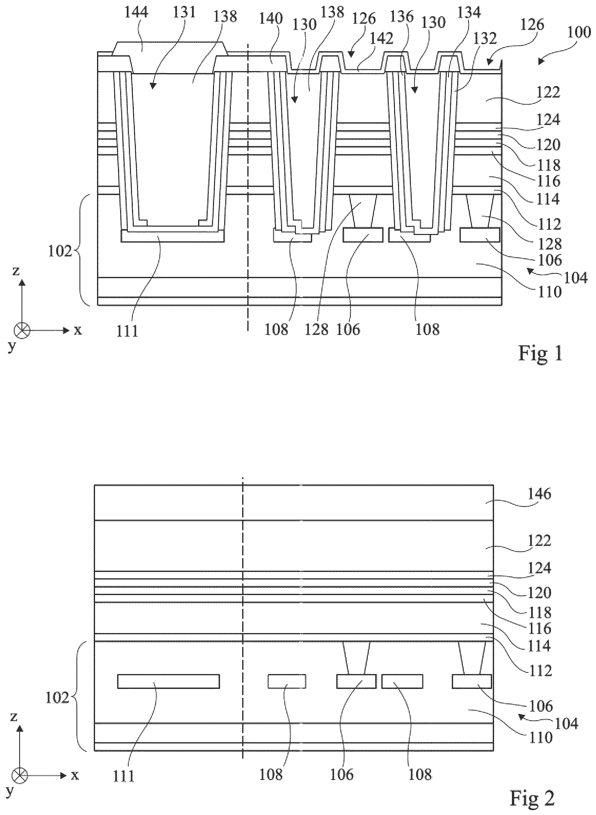

Sur les figures 1 à 14, des traits pointillés sont représentés pour illustrer le fait que les éléments du dispositif 100 représentés de chaque côté de ces traits pointillés ne sont pas nécessairement disposés directement les uns à côté des autres.

Un exemple d'un dispositif optoélectronique 100 selon un premier mode de réalisation est décrit ci-dessous en lien avec la figure 1.

Dans l'exemple de réalisation décrit, le dispositif 100 comporte un circuit intégré de commande 102 comprenant au moins, dans un niveau de métallisation 104, des premières électrodes 106 et des deuxièmes électrodes 108. Le circuit 102, qui correspond par exemple à un ASIC (« Applicationspecific integrated circuit » en anglais, ou circuit intégré spécialisé), comporte des composants électroniques permettant notamment de mettre en œuvre différentes fonctions de commande de diodes du dispositif 100, ces fonctions n'étant pas détaillées ici. Sur la figure 1, seul le niveau 104 est représenté, bien que le circuit 102 puisse comporter plusieurs niveaux de métallisations superposés réalisant les connexions électriques des composants électroniques du circuit 102.

Sur l'exemple de la figure 1, le niveau 104 comporte une couche diélectrique 110 dans laquelle sont disposées les électrodes 106, 108. Cette couche diélectrique 110 comporte par exemple du SiO₂ et son épaisseur (dimension parallèle à l'axe Z sur la figure 1) est par exemple égale à 1 µm.

Dans l'exemple de réalisation décrit, les premières électrodes 106 correspondent à des anodes des diodes du dispositif 100, et les deuxièmes électrodes 108 correspondent à des électrodes auxquelles des grilles entourant les jonctions p-n des diodes du dispositif 100 sont couplées électriquement. Sur la figure 1, seulement deux premières électrodes 106 et deux deuxièmes électrodes 108 sont représentées. Le nombre total de premières et deuxièmes électrodes 106, 108 du dispositif 100 dépend notamment du nombre de diodes du dispositif 100. En variante, d'autres configurations des premières et deuxièmes électrodes 106, 108 sont possibles.

Dans l'exemple de réalisation décrit, le circuit 102 comporte également, dans le niveau 104, au moins une troisième électrode 111 servant de cathode des diodes du dispositif 100. Sur l'exemple de la figure 1, le dispositif 100 comporte une troisième électrode 111 formant une cathode commune aux diodes du dispositif 100. De plus, dans l'exemple de réalisation décrit, la troisième électrode 111 est disposée en périphérie du dispositif 100, c'est-à-dire au niveau d'un bord du dispositif 100 et non au sein de l'ensemble de diodes du dispositif 100.

Les électrodes 106, 108, 111 comporte par exemple un matériau métallique tel que de l'aluminium ou du cuivre.

Dans l'exemple de réalisation décrit, le dispositif 100 comporte en outre plusieurs couches métalliques empilées sur le circuit intégré 102. Sur l'exemple de la figure 1, ces couches métalliques correspondent à :
- un premier empilement 112 de Ti/TiN, comportant par exemple une épaisseur de titane égale à 5 nm et une épaisseur de TiN égale à 30 nm ;
- une couche de titane 114 comportant par exemple une épaisseur égale à 500 nm ;
- un deuxième empilement 116 de Ti/TiN, comportant par exemple une épaisseur de titane égale à 10 nm et une épaisseur de TiN égale à 40 nm.

Dans cet exemple de réalisation du dispositif 100, ces couches métalliques 112, 114, 116 servent notamment à la mise en œuvre, lors de la réalisation du dispositif 100, d'un collage direct métal / métal entre d'un côté le premier empilement 112 et une partie de la couche 114 réalisés sur le circuit 102, et de l'autre le deuxième empilement 116 et une autre partie de la couche 114 réalisés sur un empilement de couches servant à la réalisation des diodes du dispositif 100. En variante, ces couches métalliques pourraient être différentes de celles décrites sur l'exemple de la figure 1, aussi bien en termes de nombre de couches, d'épaisseurs, de matériaux, etc.

Dans l'exemple de réalisation décrit, une couche d'AlSi 118 est disposée sur le deuxième empilement 116, et comporte par exemple une épaisseur égale à 100 nm.

Le dispositif 100 comporte en outre une pluralité de diodes 126 comportant chacune une partie d'un empilement d'au moins une première et une deuxième couches semi-conductrices 120, 122 dopées selon des types de conductivité opposés. Sur l'exemple de la figure 1, le semi-conducteur de la première couche 120 est dopé p, et le semi-conducteur de la deuxième couche 122 est dopé n. De plus, dans cet exemple, cet empilement semi-conducteur comporte en outre une zone active 124 disposée entre les couches 120, 122 et comprenant une ou plusieurs couches émissives ou réceptrices (optiquement absorbantes) formant chacune un puits quantique et chacune disposée entre deux couches barrières. Toutes les couches de la zone active 124, c'est-à-dire la ou les couches émissives/réceptrices et les couches barrières, comportent des matériaux semi-conducteurs intrinsèques, c'est-à-dire non intentionnellement dopés (de concentration en donneurs résiduels n_{nid} par exemple comprise entre environ 10¹⁵ et 10¹⁸ donneurs/cm³). L'empilement semi-conducteur est disposé, par exemple collé, sur le niveau 104 (avec, dans l'exemple de la figure 1, les couches 112 à 118 disposées entre le niveau 104 et l'empilement semi-conducteur) et forme ici, pour chaque diode 126, une jonction p-i-n.

Les matériaux semi-conducteurs des couches 120, 122, 124 comportent par exemple du nitrure de gallium et/ou d'aluminium et/ou d'indium. Selon un exemple de réalisation, cet empilement semi-conducteur est tel qu'il comporte :
- une première couche 120 comprenant du p-GaN et d'épaisseur par exemple égale à 120 nm ;
- une deuxième couche 122 comprenant du n-GaN et d'épaisseur par exemple égale à 500 nm ;
- une zone active 124 comprenant une ou plusieurs couches émissives d'InGaN et des couches barrière de GaN, et dont l'épaisseur est par exemple comprise entre 50 nm et 80 nm.

Selon un autre exemple de réalisation, les première et deuxième couches 120, 122 peuvent comporter de l'AlGaN et la ou les couches de la zone active 124 peuvent comporter du GaN.

En variante, d'autres familles de matériaux semi-conducteurs peuvent être employés pour la réalisation des couches 120, 122, 124, par exemple des semi-conducteurs de type arséniure ou phosphure.

Dans le premier mode de réalisation, toutes les diodes 126 du dispositif 100 correspondent à des LEDs.

Sur l'exemple de la figure 1, deux diodes 126 sont représentées, chacune comprenant une partie de l'empilement de couches 120, 122, 124. Une portion de la première couche semi-conductrice 120 de chaque diode 126 est couplée électriquement à une des premières électrodes 106 disposée sous cette portion de la première couche semi-conductrice 120, ce couplage électrique étant réalisé par l'intermédiaire d'un via électriquement conducteur 128 formé entre la première électrode 106 et les parties des couches métalliques 112, 114, 116 disposées sur cette première électrode 106 et qui sont en contact avec cette portion de la première couche semi-conductrice 120.

En variante, il est possible que l'interface entre le circuit 102 et l'empilement semi-conducteur des diodes 126, ou entre le niveau 104 et l'empilement semi-conducteur des diodes 126, soit formée par des couches différentes des couches 112 à 118, selon notamment les techniques mises en œuvre pour la réalisation du dispositif 100.

Le dispositif 100 comporte également des tranchées 130 traversant l'empilement semi-conducteur (c'est-à-dire les couches 120, 122 et 124), entourant et séparant les diodes 126 les unes des autres et dont des parois de fond sont au moins en partie formées par les deuxièmes électrodes 108. Dans l'exemple de réalisation décrit, ces tranchées 130 traversent également les couches 112, 114, 116 et 118, ainsi qu'une partie de la couche diélectrique 110 jusqu'à atteindre les deuxièmes électrodes 108.

Les tranchées 130 sont par exemple réalisées telles qu'elles forment, à travers les différentes couches dans lesquelles ces tranchées 130 sont réalisées, un quadrillage délimitant les diodes 126 dont la section, dans un plan parallèle aux plans principaux dans lesquels ces différentes couches s'étendent (plan parallèle au plan (X,Y) visible sur la figure 1), est de forme carré, hexagonale ou rectangulaire. La dimension d'une des tranchées 130 entre deux diodes 126 adjacentes, c'est-à-dire la largeur de chaque tranchée 130 (qui correspond à la dimension de la tranchée 130 parallèle à l'axe X sur la figure 1), est par exemple égale à environ 1 µm.

Dans l'exemple de réalisation décrit, une autre tranchée 131 traverse l'empilement semi-conducteur ainsi que les couches 112, 114, 116 et 118 et une partie de la couche diélectrique 110. Dans cet exemple, cette tranchée 131 comporte une paroi de fond débouchant sur la troisième électrode 111 et permet la prise de contact électrique avec la troisième électrode 111.

Dans l'exemple de réalisation décrit, les parois latérales, ou flancs, des tranchées 130, 131 sont recouvertes d'une couche diélectrique 132 servant de couche de passivation et comprenant par exemple au moins l'un des matériaux suivants : alumine, AlN, SiO₂, SiN.

Dans l'exemple de réalisation décrit, la couche diélectrique 132 est recouverte, au niveau des parois latérales des tranchées 130, 131, par une couche électriquement conductrice 134. Cette couche électriquement conductrice 134 est également disposée contre les parois de fond des tranchées 130, 131. Sur l'exemple de la figure 1, la couche électriquement conductrice 134 est donc isolée électriquement de l'empilement de couches présent sur le circuit 102 par la couche diélectrique 132. En outre, la couche électriquement conductrice 134 est couplée électriquement aux deuxièmes électrodes 108 et est interrompue de façon à ce que des parties de cette couche électriquement conductrice 134 disposées autour de chacune des diodes 126 soient isolées électriquement vis-à-vis d'autres parties de cette couche électriquement conductrice 134 disposées autour des autres diodes 126. Dans l'exemple de réalisation décrit, la couche électriquement conductrice 134 est interrompue au niveau des parois de fond des tranchées 130. Sur l'exemple de la figure 1, la couche électriquement conductrice 134 n'est pas interrompue dans la tranchée 131.

Selon un exemple de réalisation, la couche électriquement conductrice 134 comporte au moins un métal. Ce métal peut par exemple permettre une réflexion lumineuse, notamment dans le domaine visible, ce qui permet à la lumière émise latéralement par les diodes 126 de se réfléchir contre la couche électriquement conductrice 134 et éviter ainsi de perturber les diodes 126 voisines.

Dans l'exemple de réalisation décrit, la couche électriquement conductrice 134 est recouverte par une autre couche diélectrique 136 qui recouvre également les parties de la couche diélectrique 132 localisées au niveau des parties interrompues de la couche électriquement conductrice 134 (au niveau des parois de fond des tranchées 130 sur l'exemple de la figure 1). Cette autre couche diélectrique 136 comporte par exemple du SiO₂ ou de l'alumine. Sur l'exemple de la figure 1, la couche diélectrique 136 est interrompue au niveau de la paroi de fond de la tranchée 131 afin que la couche électriquement conductrice 134 soit accessible électriquement depuis le fond de la tranchée 131.

Dans l'exemple de réalisation décrit, le reste du volume des tranchées 130 non occupé par les couches 132, 134 et 136 est rempli par des portions électriquement conductrices 138 qui sont isolées électriquement vis-à-vis de la couche électriquement conductrice 134 par la couche diélectrique 136. Bien que ce ne soit pas visible sur la figure 1, les portions électriquement conductrice 138 sont ici couplées électriquement les unes aux autres en raison de la forme en quadrillage des tranchées 130. Dans un exemple de réalisation, chacune des portions électriquement conductrices 138 comporte un empilement de plusieurs matériaux, par exemple un empilement de Ti/TiN et de cuivre. Dans la tranchée 131, la portion électriquement conductrice 138 est couplée électriquement à la couche électriquement conductrice 134, et donc également à la troisième électrode 111.

Dans l'exemple de réalisation décrit, le dispositif 100 comporte en outre des portions diélectriques 140, comprenant par exemple du SiN, s'étendant sur les sommets des parties de la couche électriquement conductrice 134. De plus, le dispositif 100 comporte une couche électriquement conductrice et optiquement transparente 142 disposée sur une face supérieure du dispositif 100 et qui couple électriquement les portions électriquement conductrices 138 entre elles et aux portions de la deuxième couche semi-conductrice 122 des diodes 126. Cette couche 142 est isolée électriquement de la couche électriquement conductrice 134 par les portions diélectriques 140. La couche électriquement conductrice et optiquement transparente 142 peut comporter un oxyde transparent conducteur, par exemple de l'ITO, afin de permettre une émission lumineuse des diodes 126 à travers elle. La couche 142 assure également l'étalement (« spreading ») du courant sur la distance entre le semi-conducteur de la deuxième couche 122 et les portions électriquement conductrices 138.

Dans l'exemple de réalisation décrit, le remplissage métallique des tranchées 130, 131 permet le couplage électrique entre les portions de la deuxième couche semi-conductrice 122 des diodes 126 et la troisième électrode 111 qui correspond à la cathode commune des diodes 126. Dans l'exemple représenté sur la figure 1, le dispositif 100 comporte également un plot de connexion 144 disposé sur la portion électriquement conductrice 138 disposée dans la tranchée 131, et servant d'accès électrique à la cathode commune des diodes 126.

Ainsi, le dispositif 100 selon le premier mode de réalisation comporte des diodes 126 commandables indépendamment les unes des autres et adressables par des potentiels électriques de commande appliqués par le circuit 102 sur les anodes correspondant aux premières électrodes 106. En outre, les grilles formées par les parties de la couche électriquement conductrice 134 autour des empilements semi-conducteurs des diodes 126 sont commandables indépendamment les unes des autres et adressables par des potentiels électriques de commande appliqués par le circuit 102 sur les deuxièmes électrodes 108. L'application d'un potentiel électrique sur ces grilles peut modifier la distribution des porteurs sur les flancs latéraux du semi-conducteur dopé P ou N (selon le potentiel appliqué), ce qui permet d'augmenter l'efficacité d'émission lumineuse des diodes 126. Lors de l'application de ces potentiels électriques sur ces grilles, aucun courant ne circule dans ces grilles.

De manière avantageuse, l'épaisseur de la couche diélectrique 132 peut être choisie telle qu'elle soit suffisante pour éviter un claquage lorsqu'un potentiel électrique est appliqué sur les grilles des diodes 126, sans toutefois être trop épaisse afin de maximiser l'effet de champ appliqué par l'intermédiaire de la grille des diodes 126. A titre d'exemple, l'épaisseur de cette couche diélectrique 132 est par exemple comprise entre 10 nm et 60 nm, en fonction des caractéristiques diélectriques du ou des matériaux de cette couche 132.

De manière avantageuse, l'épaisseur de la couche diélectrique 136 peut être choisie telle qu'elle soit suffisante pour éviter un claquage du fait des potentiels électriques appliqués sur les grilles des diodes 126 et du potentiel électrique de référence, par exemple la masse, appliqué sur la cathode. Par exemple, lorsque la différence de potentiel entre la couche électriquement conductrice 134 et les portions électriquement conductrices 138 est de l'ordre de 1 V, la couche diélectrique 136 peut comporter de l'alumine et avoir une épaisseur égale à environ 10 nm.

Les flancs latéraux des tranchées 130, 131 peuvent être perpendiculaires à la surface du circuit 102 sur laquelle l'empilement semi-conducteur est solidarisé, ou bien former un angle tel que la largeur des tranchées 130, 131 au niveau de la face supérieure du dispositif 100 (face au niveau de laquelle sont présentes les portions diélectrique 140 et la couche électriquement conductrice et optiquement transparente 142) soit supérieure à la largeur de ces tranchées 130, 131 au niveau du circuit 102, c'est-à-dire de la couche diélectrique 110 sur l'exemple de la figure 1. Une telle différence de largeur des tranchées 130, 131 peut faciliter la mise en œuvre des dépôts des matériaux dans les tranchées 130, 131.

Le dispositif 100 décrit comporte donc un ensemble compact de diodes 126 à trois électrodes, dont les diodes 126 sont pilotables de manière individuelle grâce à l'indépendance électrique des anodes et des grilles de ces diodes 126.

La structure du dispositif 100 peut permettre sa réalisation par une intégration monolithique, directement sur le circuit 102, des jonctions formant les diodes 126 sans alignement critique, grâce au fait que la singularisation des diodes 126 (correspondant à la réalisation des tranchées 130) est réalisée après la solidarisation des couches semi-conductrices avec le circuit 102.

Un exemple de procédé de réalisation du dispositif 100 tel que précédemment décrit en lien avec la figure 1 est décrit ci-dessous en lien avec les figures 2 à 9.

Le circuit intégré 102 est tout d'abord réalisé à partir d'un substrat semi-conducteur, par exemple en mettant en œuvre des étapes classiques de la microélectronique (dépôt, lithographie, gravure, etc.) pour former les composants électroniques de ce circuit intégré 102 ainsi que les niveaux de métallisation (BEOL) dont le niveau de métallisation 104. Le premier empilement 112 et une partie de la couche 114 sont également réalisés sur le niveau 104 en prévision d'un futur collage direct métal / métal avec l'empilement semi-conducteur destiné à la réalisation des diodes 126.

Dans l'exemple de réalisation décrit, l'empilement semi-conducteur des couches 124, 122, 120 ainsi que la couche 118, le deuxième empilement 116 et une partie de la couche 114 sont réalisés sur un autre substrat (non représenté). Les couches 124, 122 et 120 sont par exemple réalisées par épitaxie. Une ou plusieurs couches tampon peuvent être présentes sur cet autre substrat pour faciliter la croissance des couches 124, 122, et 120.

Un collage direct de type métal / métal peut ensuite être mis en œuvre pour solidariser les deux parties de la couche 114 l'une avec l'autre, puis le substrat ayant servi à la croissance des couches 124, 122 et 120 peut être retiré. La ou les éventuelles couches tampon interposées entre le substrat et la couche 124 peuvent également être retirées, par exemple par amincissement et gravure.

En variante, d'autres types de solidarisation peuvent être mises en œuvre pour solidariser le circuit 102 avec l'empilement semi-conducteur à partir duquel les diodes 126 seront réalisées.

Dans l'exemple de réalisation décrit, un masque dur diélectrique 146 est ensuite réalisé, par exemple par dépôt, sur la couche semi-conductrice 122. Selon un exemple, le masque dur diélectrique 146 peut comporter du SiO₂ et/ou du SiN. L'épaisseur du masque dur diélectrique 146 est ici choisie telle qu'elle soit suffisante pour pouvoir graver les tranchées 130, 131 jusqu'à atteindre les électrodes 106, 108, 111. La structure obtenue à ce stade du procédé est représentée sur la figure 2.

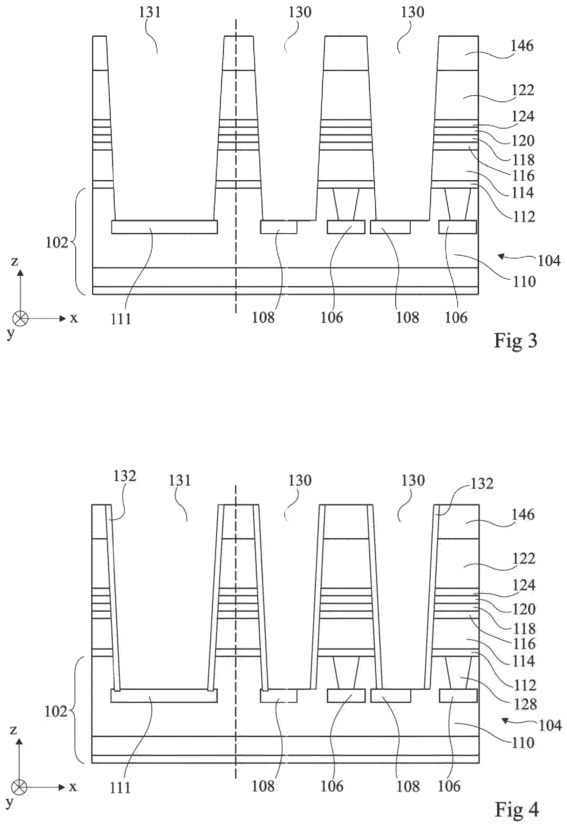

Les tranchées 130, 131 sont ensuite réalisées à travers l'empilement semi-conducteur jusqu'aux électrodes 111, 106 et 108. Dans l'exemple de réalisation décrit, une lithographie et une gravure peuvent ensuite être mises en œuvre, en utilisant le masque dur diélectrique 146, pour former les tranchées 130, 131 à travers les couches présentes sur les électrodes 106, 108 et 111. La gravure mise en œuvre peut utiliser judicieusement une couche d'arrêt comprenant par exemple du TiN et/ou du SiN et présente sur le niveau métallique des électrodes 106, 108, 111. L'utilisation d'une telle couche d'arrêt permet que d'éventuelles variations d'épaisseur des matériaux gravés n'impactent pas la profondeur finale des tranchées 130, 131. Cette gravure des tranchées 130, 131 jusqu'au niveau de métallisation comprenant les électrodes 106, 108, 111 permet de réaliser ensuite les différentes reprises de contact. La structure obtenue à ce stade du procédé est représentée sur la figure 3.

Dans l'exemple de réalisation décrit, la couche diélectrique 132 est ensuite déposée dans les tranchées 130, 131 en recouvrant les parois latérales et les parois de fond de ces tranchées 130, 131, et également sur le masque dur diélectrique 146. Une gravure anisotrope peut ensuite être mise en œuvre afin de supprimer les parties de la couche diélectrique 132 disposées sur les parois de fond des tranchées 130, 131 ainsi que celles reposant sur le masque dur diélectrique 146. Les portions restantes de la couche diélectrique 132 forment des espaceurs diélectriques recouvrant les flancs, ou parois latérales, des diodes 126. La structure obtenue à ce stade du procédé est représentée sur la figure 4.

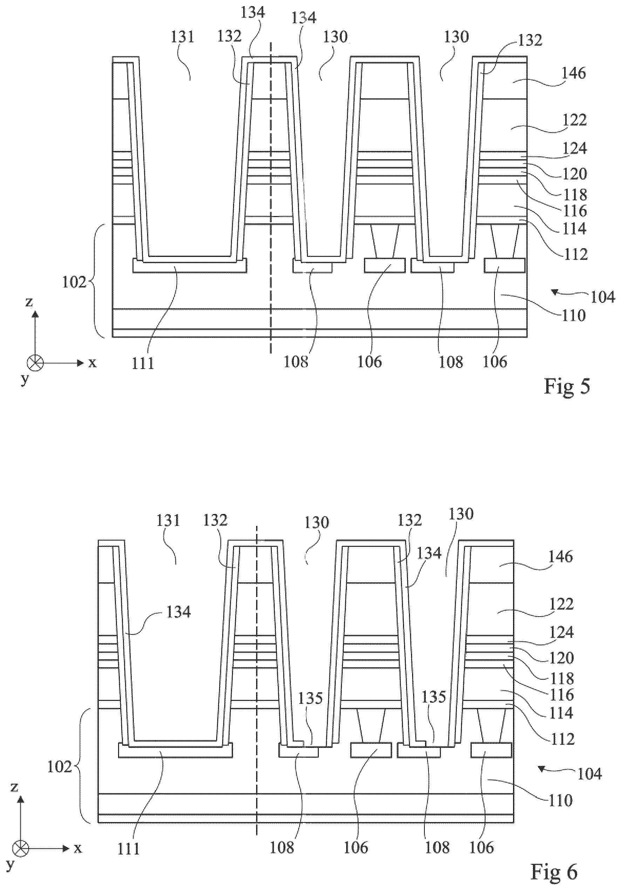

La couche électriquement conductrice 134 est ensuite déposée sur la structure réalisée, recouvrant ainsi, les parois de fond des tranchées 130, 131, le masque dur diélectrique 146 ainsi que les portions restantes de la couche diélectrique 132 disposées contre les parois latérales des tranchées 130, 131. Dans les tranchées 130, la couche électriquement conductrice 134 est en contact électriquement avec les deuxièmes électrodes 108, c'est-à-dire celles destinées à former les grilles des diodes 126 dans l'exemple décrit. Préalablement à ce dépôt, une ou plusieurs étapes de préparation des surfaces sur lesquelles la couche électriquement conductrice 134 est destinée à être déposée peuvent être mises en œuvre, par exemple pour retirer un éventuel oxyde métallique natif présent sur ces surfaces. La structure obtenue à ce stade du procédé est représentée sur la figure 5.

Une étape de gravure localisée peut ensuite être mise en œuvre afin de supprimer certaines portions de la couche électriquement conductrice 134 tel que des parties de la couche électriquement conductrice 134 disposées autour de chacune des diodes 126 soient isolées électriquement vis-à-vis d'autres parties de la couche électriquement conductrice 134 disposées autour des autres diodes 126. Autrement dit, cette gravure peut être mise en œuvre telle que les parties restantes de la couche électriquement 134 soient isolées électriquement d'un pixel à l'autre tout en conservant un contact électrique, pour les parties restantes de la couche 134, autour de chaque diode 126, avec l'une des deuxièmes électrodes 108. Dans l'exemple de réalisation décrit, les parties gravées de la couche électriquement conductrice 134 (désignées par la référence 135 sur la figure 6) sont localisées sur les parois de fond des tranchées 130. Dans l'exemple décrit, cette gravure est mise en œuvre de manière telle que les parties de la couche électriquement conductrice 134 localisées dans la tranchée 131 ne soient pas gravées et que le contact électrique avec la troisième électrode 111 soit maintenu. En variante, il est possible que les parties de la couche électriquement conductrice 134 localisées dans la tranchée 131 soient gravées. La structure obtenue à ce stade du procédé est représentée sur la figure 6.

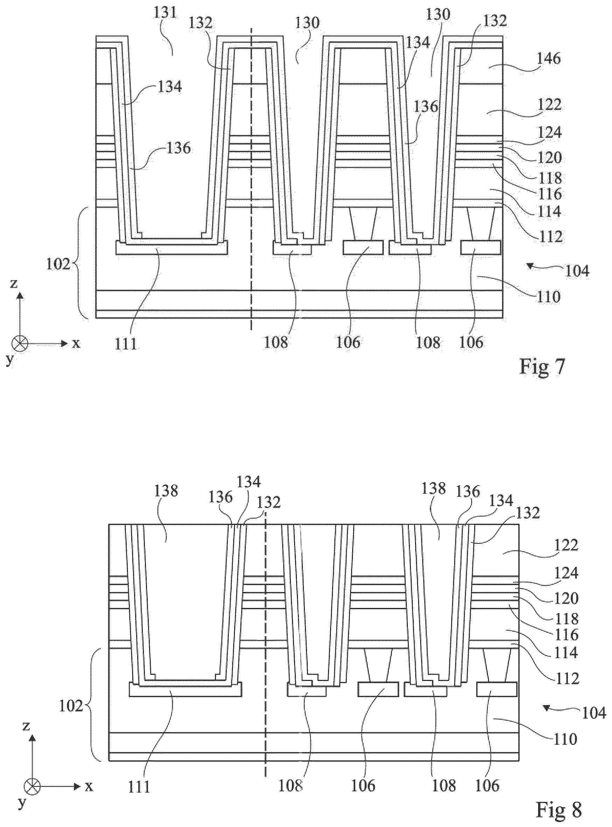

Dans l'exemple de réalisation décrit, la couche diélectrique 136 est ensuite déposée sur la couche électriquement conductrice 134, et également sur les parties des parois de fond des tranchées 130 qui ne sont plus recouverts par la couche électriquement conductrice 134 (c'est-à-dire aux emplacements des parties gravées 135). Une gravure localisée peut ensuite être mise en œuvre afin de supprimer la partie de la couche diélectrique 136 recouvrant la paroi de fond de la tranchée 131 afin que la couche électriquement conductrice 134 reste accessible électriquement depuis le fond de la tranchée 131. La structure obtenue à ce stade du procédé est représentée sur la figure 7.

Dans l'exemple de réalisation décrit, les portions électriquement conductrices 138 sont ensuite réalisées de manière à ce qu'elles remplissent le volume restant des tranchées 130, 131 non occupé par les autres couches précédemment déposées. Selon un exemple de réalisation, la réalisation des portions 138 peut comporter le dépôt de couches de Ti/TiN/Cu à partir desquelles une croissance électrochimique de cuivre est ensuite mise en œuvre.

Une planarisation de la face supérieure de la structure réalisée peut ensuite être mise en œuvre, avec arrêt sur la deuxième couche semi-conductrice 122. Ce polissage mécano-chimique permet de supprimer le masque dur diélectrique 146 ainsi que les parties des couches 134 et 136 et des portions 138 disposées au niveau du masque dur diélectrique 146. La structure obtenue à ce stade du procédé est représentée sur la figure 8.

Dans l'exemple de réalisation décrit, une couche d'encapsulation diélectrique 140 est ensuite déposée sur la face supérieure de la structure réalisée, cette couche 140 étant ensuite gravée localement afin de supprimer les parties de cette couche recouvrant les portions électriquement conductrices 138 et la deuxième couche semi-conductrice 122. Les parties restantes de cette couche d'encapsulation forment les portions diélectriques 140.

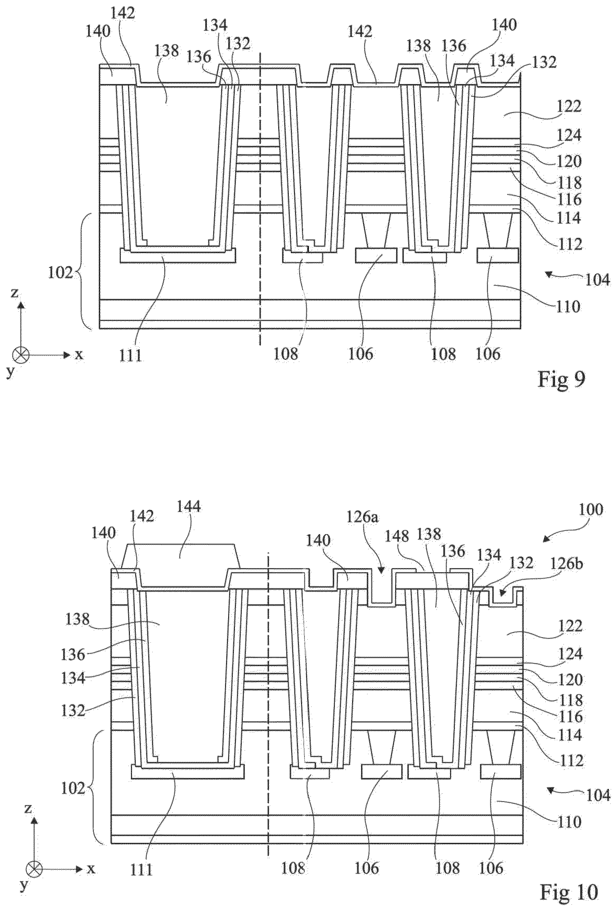

Dans l'exemple de réalisation décrit, la couche électriquement conductrice et optiquement transparente 142 est ensuite déposée sur la face supérieure de la structure réalisée, réalisant ainsi les contacts électriques entre les parties de la deuxième couche semi-conductrice 122 des diodes 126 et les portions électriquement conductrices 138, et également avec la portion électriquement conductrice 138 qui est en contact avec la troisième électrode 111 correspondant à la cathode commune des diodes 126. La structure obtenue à ce stade du procédé est représentée sur la figure 9.

Le dispositif 100 peut être ensuite achevé en mettant en œuvre un dépôt de passivation électrique/chimique et en réalisant des plots de connexion, dont le plot de connexion 144 servant de contact à la cathode commune du dispositif 100. Le dispositif 100 obtenu correspond à celui représenté sur la figure 1. En variante, d'autres plots de connexion couplés aux anodes et/ou aux deuxièmes électrodes 128 peuvent également réalisés via un routage dans les niveaux de métallisation du circuit.

Dans l'exemple de réalisation du dispositif 100 précédemment décrit en lien avec la figure 1, toutes les diodes 126 du dispositif correspondent à des LEDs. En variante, il est possible qu'au moins une partie de ces diodes 126 correspondent à des photodiodes. Dans ce cas, la zone active 124 peut comporter une ou plusieurs couches réceptrices, c'est-à-dire optiquement absorbantes.

Un exemple d'un dispositif optoélectronique 100 selon un deuxième mode de réalisation est décrit ci-dessous en lien avec la figure 10.

Dans ce deuxième mode de réalisation, le dispositif 100 comporte certaines diodes 126 correspondant à des LEDs et d'autres diodes 126 correspondant à des photodiodes. Sur la figure 10, la diode désignée par la référence 126a correspond à une LED et est similaire aux diodes 126 du dispositif 100 selon le premier mode de réalisation précédemment décrit. Ainsi, la partie de la deuxième couche semi-conductrice 122 de cette diode 126a est couplée électriquement à l'une des portions électriquement conductrices 138 adjacentes à cette partie de la deuxième couche semi-conductrice 122 afin qu'elle soit couplée à la cathode commune des LEDs du dispositif 100. De plus, un potentiel électrique différent des potentiels électriques appliqués sur l'anode et la cathode de cette diode 126a est destiné à être appliqué sur la grille de cette diode 126a formée par les parties de la couche électriquement conductrice 134 disposées autour de l'empilement semi-conducteur de cette diode 126a.

Sur l'exemple de la figure 10, la diode désignée par la référence 126b correspond à une photodiode qui se distingue de la diode 126a du fait que le potentiel électrique destiné à être appliqué sur la partie de la deuxième couche semi-conductrice 122 de cette photodiode 126b ne correspond pas à celui de la cathode commune mais à celui destiné à être appliqué sur la grille de cette diode 126b formée par les parties de la couche électriquement conductrice 134 disposées autour de l'empilement semi-conducteur de cette diode 126b. Cette configuration de la diode 126b est obtenue grâce au fait que la portion diélectrique 140 formée à côté de cette diode 126b recouvre la portion électriquement conductrice 138 et non l'une des parties de la couche électriquement conductrice 134 disposées autour de l'empilement semi-conducteur de cette diode 126b. Ainsi, la partie de la couche électriquement conductrice et optiquement transparente 142 formée au-dessus de cette diode 126b couple électriquement la partie de la deuxième couche semi-conductrice 122 de cette diode 126b à l'une des parties de la couche électriquement conductrice 134 disposées autour de l'empilement semi-conducteur de cette diode 126b. En outre, dans cette configuration, la couche électriquement conductrice 142 n'est pas continue mais est interrompue (interruption désignée par la référence 148 sur la figure 10) pour que les parties de la couche 134 assurant des liaisons électriques pour les diodes correspondant à des LEDs ne soient pas reliées électriquement à celles assurant des liaisons électriques pour les diodes correspondant à des photodiodes.

Dans ce deuxième mode de réalisation, la couche électriquement conductrice et optiquement transparente 142 permet de différencier le potentiel électrique appliqué sur les parties de la deuxième couche semi-conductrice 122 selon la nature des diodes 126. Ainsi, pour les diodes 126 correspondant à des photodiodes, il est possible d'appliquer sur les parties de la deuxième couche semi-conductrice 122 de ces photodiodes le même potentiel électrique que celui appliqué sur les anodes des diodes 126 correspondant à des LEDs. Ainsi, le circuit 102 n'a pas à fournir de tensions opposées aux LEDs et aux photodiodes du dispositif 100, étant donné que la même tension peut être utilisée pour la polarisation des LEDs et des photodiodes.

Dans une configuration particulière, le dispositif 100 peut comporter une matrice de pixels telle que chaque pixel de la matrice comporte une première diode similaire à la diode 126a et correspondant à une LED, et une deuxième diode similaire à la diode 126b et correspondant à une photodiode. Chaque pixel d'une telle matrice remplit donc à la fois une fonction d'émission lumineuse et une fonction de réception lumineuse.

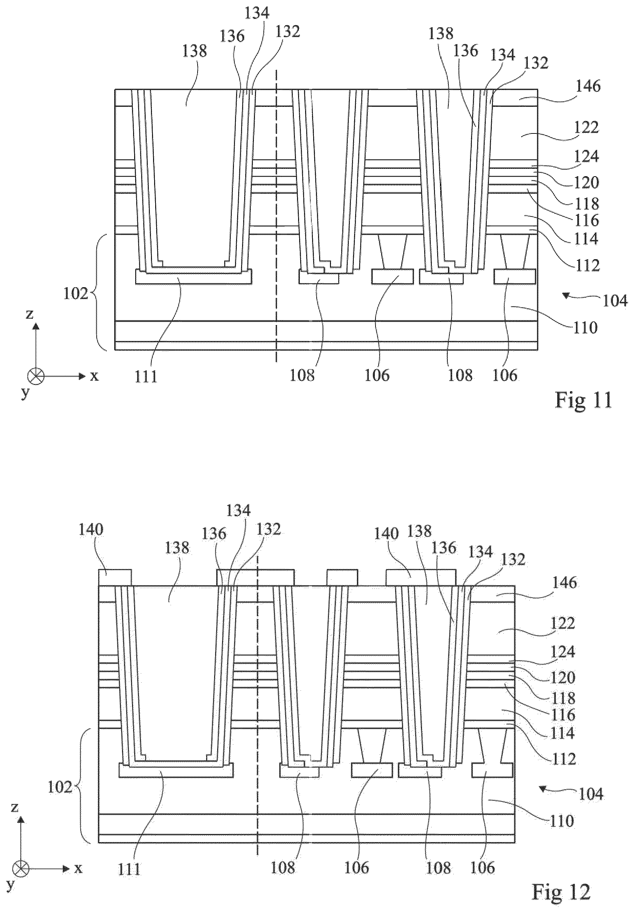

Un exemple de procédé de réalisation du dispositif 100 selon le deuxième mode de réalisation est décrit ci-dessous en lien avec les figures 11 à 14.

Les étapes précédemment décrites en lien avec les figures 2 à 8 sont tout d'abord mises en œuvre, avec toutefois pour différence que la planarisation de la face supérieure de la structure réalisée est mise en œuvre avec arrêt non pas sur la deuxième couche semi-conductrice 122 mais sur le masque dur diélectrique 146. La structure obtenue à ce stade du procédé est représentée sur la figure 11.

La couche d'encapsulation diélectrique est ensuite déposée sur la face supérieure de la structure réalisée. Cette couche est ensuite gravée localement, par exemple via une photolithographie, afin de supprimer, au niveau des diodes 126a destinées à former des LEDs, les parties de cette couche recouvrant les portions électriquement conductrices 138 et le masque dur diélectrique 146, et supprimer, au niveau des diodes 126b destinées à former des photodiodes, les parties de cette couche recouvrant les parties de la couche électriquement conductrice 134 et le masque dur diélectrique 146. Au niveau des diodes 126 destinées à former des photodiodes, une épaisseur suffisamment importante de la couche diélectrique 136, correspondant par exemple à une couche de SiO₂ d'épaisseur égale à environ 200 nm, facilite la mise en œuvre de cette gravure de manière à graver les parties de la couche d'encapsulation localisées sur les parties de la couche électriquement conductrice et conserver celles localisées sur les portions électriquement conductrices 138. Les parties restantes de cette couche d'encapsulation forment les portions diélectriques 140. La structure obtenue à ce stade du procédé est visible sur la figure 12.

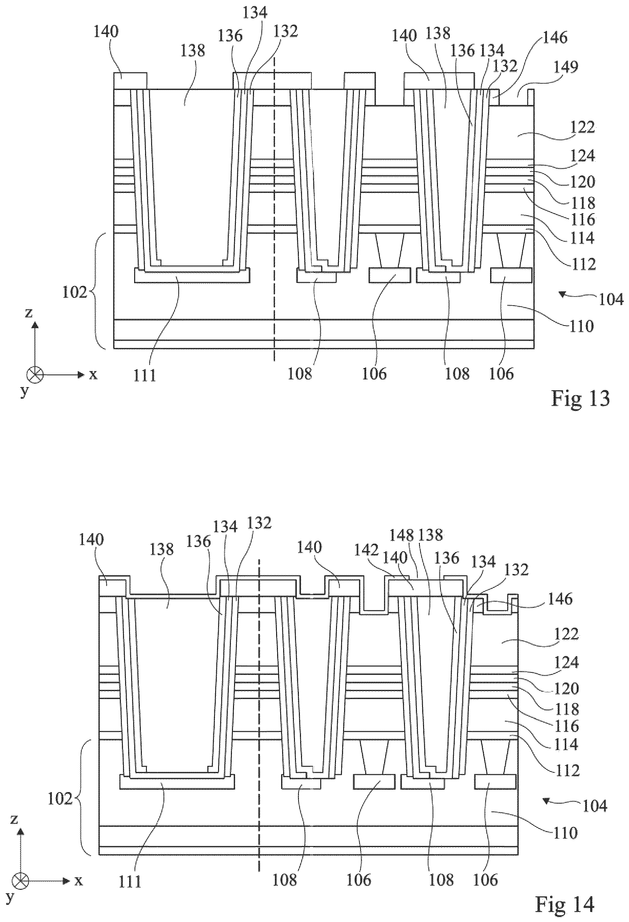

Une deuxième étape de photolithographie et de gravure est ensuite mise en œuvre pour former des ouvertures 149 à travers le masque dur diélectrique 146 permettant d'accéder aux parties de la deuxième couche semi-conductrice 122 des diodes 126a et 126b. La structure obtenue à ce stade du procédé est représentée sur la figure 13.

La couche électriquement conductrice et optiquement transparente 142 est ensuite déposée sur la face supérieure de la structure réalisée, réalisant ainsi les contacts électriques entre les parties de la deuxième couche semi-conductrice 122 et les portions électriquement conductrices 138 pour les diodes 126a correspondant à des LEDs, et les contacts électriques entre les parties de la deuxième couche semi-conductrice 122 et les parties de la couche électriquement conductrice 134 pour les diodes 126b correspondant à des photodiodes. Des étapes de photolithographie et gravure de la couche électriquement conductrice 142 peuvent ensuite être mises en œuvre afin que la couche électriquement conductrice 142 soit interrompue pour que les parties de cette couche 142 assurant des liaisons électriques pour les diodes correspondant à des LEDs ne soient pas reliées électriquement à celles assurant des liaisons électriques pour les diodes correspondant à des photodiodes. La structure obtenue à ce stade du procédé est représentée sur la figure 14.

Le dispositif 100 peut être achevé comme précédemment décrit pour le premier mode de réalisation, le dispositif 100 obtenu correspondant à celui représenté sur la figure 10.

Dans les exemples de réalisation du dispositif 100 précédemment décrits, la troisième électrode 111 forme une cathode commune à l'ensemble des diodes 126 correspondant à des LEDs. De plus, dans ces exemples, la troisième électrode 111 est disposée au niveau d'un bord du dispositif 100, par exemple à côté de la matrice de diodes 126.

Dans une première variante pouvant s'appliquer au premier ou au deuxième mode de réalisation précédemment décrits, il est possible que chaque première électrode 106 soit disposée entre deux deuxièmes électrodes 108 auxquelles sont couplées électriquement les parties de la couche électriquement conductrice 134 localisées autour de la diode 126 dont la portion de la première couche semi-conductrice 120 est couplée électriquement à ladite première électrode 106. En outre, dans cette première variante, le dispositif 100 peut comporter plusieurs troisièmes électrodes 111 disposées dans le niveau de métallisation 104, chacune des troisièmes électrodes 111 étant couplée électriquement à l'une des portions électriquement conductrices 138 et disposée entre deux deuxièmes électrodes 108 chacune couplée électriquement à des parties de la couche électriquement conductrice 134 localisées autour de diodes 126 différentes.

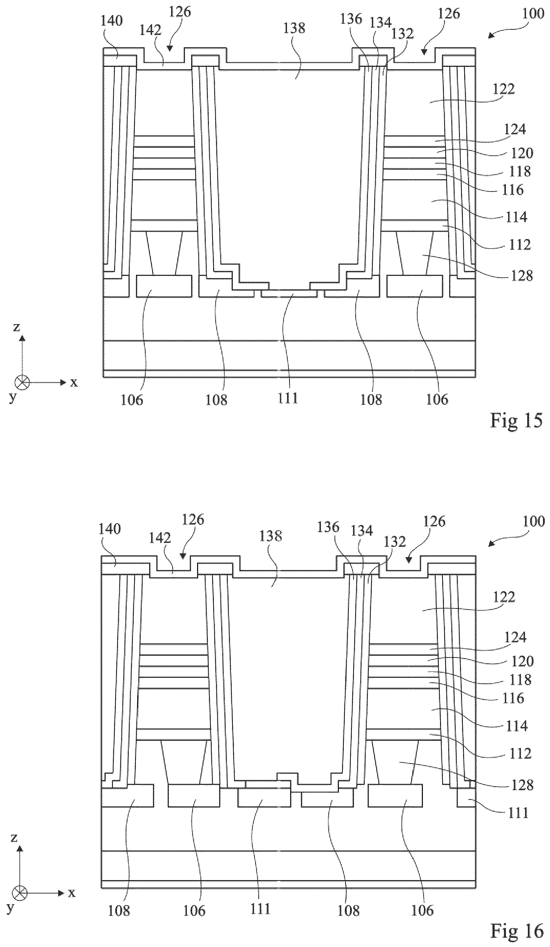

Un exemple d'une partie d'un dispositif 100 selon une telle variante appliquée ici au dispositif 100 selon le premier mode de réalisation est représenté sur la figure 15. Comme cela est visible sur cette figure, les parties de la couche électriquement conductrice 134 et de la couche diélectrique 136 localisées sur les parois de fond des tranchées 130 et recouvrant les troisièmes électrodes 111 sont gravées afin que les portions électriquement conductrices 138 soient en contact électriquement avec les troisièmes électrodes 111. En outre, les parties de la couche électriquement conductrice 134 disposées dans une même tranchée sont couplées électriquement à des deuxièmes électrodes 108 différentes l'une de l'autre.

Cette première variante peut faciliter la réalisation du dispositif 100, avec toutefois comme contrepartie une compacité moindre du dispositif 100 ainsi réalisé par rapport à un dispositif 100 comportant une seule troisième électrode 111 localisée en bord du dispositif 100.

Dans une deuxième variante pouvant s'appliquer au premier ou au deuxième mode de réalisation précédemment décrits, il est possible que le dispositif 100 comporte plusieurs troisièmes électrodes 111 chacune couplée électriquement à l'une des portions électriquement conductrices 138 et disposées dans le niveau de métallisation 104, chacune des premières électrodes 106 étant disposée entre une des deuxièmes électrodes 108 et une des troisièmes électrodes 111, et chacune des troisièmes électrodes 111 est disposée entre une des premières électrodes 106 et une des deuxièmes électrodes 108.

Un exemple d'une telle deuxième variante appliquée ici au dispositif 100 selon le premier mode de réalisation est représenté sur la figure 16. Comme cela est visible sur cette figure, la couche électriquement conductrice 134 et la couche diélectrique 136 sont gravées telles que l'une des portions de la couche électriquement conductrice 134 soit en contact électriquement avec la deuxième électrode 108 localisée au fond de la tranchée 130 et que la portion électriquement conductrice 138 soit en contact avec la troisième électrode 111 localisée au fond de la tranchée 130. En outre, sur l'exemple de la figure 16, une partie de la couche électriquement conductrice 134 peut être conservée sur la troisième électrode 111, la portion électriquement conductrice 134 étant couplée électriquement à la troisième électrode 111. En variante, cette partie de la couche électriquement conductrice 134 peut être supprimée.

Comme la première variante, cette deuxième variante permet de faciliter la réalisation du dispositif 100, avec toutefois comme contrepartie une compacité moindre que lorsque le dispositif 100 comporte une seule troisième électrode 111 localisée en bord du dispositif 100.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus.

L'étendue de la présente invention est définie par les revendications qui suivent.

## Revendications

1. Dispositif optoélectronique (100) comprenant au moins :
- une pluralité de diodes (126) comportant chacune une partie d'un empilement d'au moins une première et une deuxième couches semi-conductrices (120, 122) dopées selon des types de conductivité opposés, une portion de la première couche semi-conductrice (120) de chaque diode (126) étant couplée électriquement à une première électrode (106) disposée sous ladite portion de la première couche semi-conductrice (120) ;
- des tranchées (130) traversant l'empilement, séparant les diodes (126) les unes des autres et depuis lesquelles des deuxièmes électrodes (108) sont accessibles électriquement ;
- une couche électriquement conductrice (134) disposée au moins contre des parois latérales des tranchées (130), isolée électriquement de l'empilement, couplée électriquement aux deuxièmes électrodes (108) et qui est interrompue de telle manière que des parties de la couche électriquement conductrice (134) disposées autour de chacune des diodes (126) soient isolées électriquement vis-à-vis d'autres parties de la couche électriquement conductrice (134) disposées autour des autres diodes (126) ;
- des portions électriquement conductrices (138) disposées dans les tranchées (130), isolées électriquement de la couche électriquement conductrice (134) et couplées électriquement les unes aux autres et à au moins une troisième électrode (111) ;
et **caractérisé en ce que** des parois de fond des tranchées (130) sont au moins en partie formées par les deuxièmes électrodes (108).

2. Dispositif optoélectronique (100) selon la revendication 1, dans lequel la couche électriquement conductrice (134) est interrompue au niveau de parois de fond des tranchées (130).

3. Dispositif optoélectronique (100) selon l'une des revendications précédentes, dans lequel les portions électriquement conductrices (138) sont couplées électriquement aux portions de la deuxième couche semi-conductrice (122) d'au moins une partie des diodes (126) correspondant à des diodes électroluminescentes, LEDs.

4. Dispositif optoélectronique (100) selon la revendication 3, dans lequel les portions électriquement conductrices (138) sont couplées électriquement aux portions de la deuxième couche semi-conductrice (122) des LEDs par au moins une couche électriquement conductrice et optiquement transparente (142) disposée sur l'empilement et sur les portions électriquement conductrices (138).

5. Dispositif électronique (100) selon la revendication 4, dans lequel la couche électriquement conductrice et optiquement transparente (142) est isolée électriquement de la couche électriquement conductrice (134) par des portions diélectriques (140) disposées entre la couche électriquement conductrice (134) et la couche électriquement conductrice et optiquement transparente (142).

6. Dispositif optoélectronique (100) selon l'une des revendications précédentes, dans lequel les portions électriquement conductrices (138) sont isolées électriquement de la couche électriquement conductrice (134) par au moins une première couche diélectrique (136) disposée entre les portions électriquement conductrices (138) et la couche électriquement conductrice (134).

7. Dispositif optoélectronique (100) selon l'une des revendications précédentes, dans lequel la troisième électrode (111) est disposée au niveau d'un bord du dispositif optoélectronique (100).

8. Dispositif optoélectronique (100) selon l'une des revendications 1 à 6, dans lequel :
- chaque première électrode (106) est disposée entre deux deuxièmes électrodes (108) auxquelles sont couplées électriquement les parties de la couche électriquement conductrice (134) localisées autour de la diode (126) dont la portion de la première couche semi-conductrice (120) est couplée électriquement à ladite première électrode (106), et
- le dispositif optoélectronique (100) comporte plusieurs troisièmes électrodes (111) chacune couplée électriquement à l'une des portions électriquement conductrices (138) et disposée entre deux deuxièmes électrodes (108) chacune couplée électriquement à des parties de la couche électriquement conductrice (134) localisées autour de diodes (126) différentes.

9. Dispositif optoélectronique (100) selon l'une des revendications 1 à 6, comportant plusieurs troisièmes électrodes (111) chacune couplée électriquement à l'une des portions électriquement conductrices (138), chacune des premières électrodes (106) étant disposée entre une des deuxièmes électrodes (108) et une des troisièmes électrodes (111), et chacune des troisièmes électrodes (111) est disposée entre une des premières électrodes (106) et une des deuxièmes électrodes (108).

10. Dispositif optoélectronique (100) selon l'une des revendications précédentes, dans lequel les parties de la couche électriquement conductrice (134) disposées autour d'au moins une partie des diodes (126) correspondant à des photodiodes sont couplées électriquement aux portions de la deuxième couche semi-conductrice (122) des photodiodes.

11. Dispositif optoélectronique (100) selon la revendication 10, dans lequel les parties de la couche électriquement conductrice (134) disposées autour des photodiodes sont couplées électriquement aux portions de la deuxième couche semi-conductrice (122) des photodiodes par au moins une couche électriquement conductrice et optiquement transparente (142) disposée sur l'empilement et sur les parties de la couche électriquement conductrice (134) disposées autour des photodiodes.

12. Dispositif optoélectronique (100) selon l'une des revendications précédentes, comportant en outre une couche de passivation (132) disposée entre la couche électriquement conductrice (134) et l'empilement.

13. Procédé de réalisation d'un dispositif optoélectronique (100), comportant au moins les étapes de :
- réalisation d'un empilement d'au moins une première et une deuxième couches semi-conductrices (120, 122) dopées selon des types de conductivité opposés ;
- réalisation de tranchées (130) traversant l'empilement, séparant les unes des autres des diodes (126) comportant chacune une partie de l'empilement et rendant accessibles des deuxièmes électrodes (108) telles que des parois de fond des tranchées (130) soient au moins en partie formées par les deuxièmes électrodes (108), une portion de la première couche semi-conductrice (120) de chaque diode (126) étant couplée électriquement à une première électrode (106) disposée sous ladite portion de la première couche semi-conductrice (120) ;
- réalisation d'une couche électriquement conductrice (134) disposée au moins contre des parois latérales des tranchées (130), isolée électriquement de l'empilement, couplée électriquement aux deuxièmes électrodes (108) et qui est interrompue telle que des parties de la couche électriquement conductrice (134) disposées autour de chacune des diodes (126) soient isolées électriquement vis-à-vis des parties de la couche électriquement conductrice (134) localisées autour des autres diodes (126) ;
- réalisation de portions électriquement conductrices (138) disposées dans les tranchées (130), isolées électriquement de la couche électriquement conductrice (134) et couplées électriquement les unes aux autres et à au moins une troisième électrode (111).

## Patentansprüche

1. Optoelektronische Vorrichtung (100), die wenigstens Folgendes aufweist:
• eine Vielzahl von Dioden (126), die jeweils einen Abschnitt eines Stapels von wenigstens einer ersten und einer zweiten Halbleiterschicht (120, 122), die gemäß entgegengesetzten Leitfähigkeitstypen dotiert sind, aufweisen, wobei ein Abschnitt der ersten Halbleiterschicht (120) jeder Diode (126) elektrisch mit einer ersten Elektrode (106) gekoppelt ist, die unter dem Abschnitt der ersten Halbleiterschicht (120) angeordnet ist;
• Gräben (130), die sich durch den Stapel erstrecken, die die Dioden (126) voneinander trennen und von denen zweite Elektroden (108) elektrisch zugänglich sind;
• eine elektrisch leitfähige Schicht (134), die wenigstens gegen Seitenwände der Gräben (130) angeordnet ist, die elektrisch von dem Stapel isoliert ist, die elektrisch mit den zweiten Elektroden (108) gekoppelt ist und die derart unterbrochen ist, dass Abschnitte der elektrisch leitfähigen Schicht (134), die um jede der Dioden (126) angeordnet sind, elektrisch von anderen Abschnitten der elektrisch leitfähigen Schicht (134), die um die anderen Dioden (126) angeordnet sind, isoliert sind;
• elektrisch leitfähige Abschnitte (138), die in den Gräben (130) angeordnet sind, elektrisch von der elektrisch leitfähigen Schicht (134) isoliert sind und elektrisch miteinander und mit wenigstens einer dritten Elektrode (111) gekoppelt sind;
und **dadurch gekennzeichnet, dass** Bodenwände der Gräben (130) wenigstens teilweise durch die zweiten Elektroden (108) ausgebildet sind.

2. Optoelektronische Vorrichtung (100) nach Anspruch 1, wobei die elektrisch leitfähige Schicht (134) an Bodenwänden der Gräben (130) unterbrochen ist.

3. Optoelektronische Vorrichtung (100) nach einem der vorhergehenden Ansprüche, wobei die elektrisch leitfähigen Abschnitte (138) elektrisch mit den Abschnitten der zweiten Halbleiterschicht (122) von wenigstens einem Teil der Dioden (126), die Leuchtdioden, LEDs, entsprechen, gekoppelt sind.

4. Optoelektronische Vorrichtung (100) nach Anspruch 3, wobei die elektrisch leitfähigen Abschnitte (138) elektrisch mit den Abschnitten der zweiten Halbleiterschicht (122) der LEDs durch wenigstens eine elektrisch leitfähige und optisch transparente Schicht (142), die auf dem Stapel und auf den elektrisch leitfähigen Abschnitten (138) angeordnet ist, gekoppelt sind.

5. Elektronische Vorrichtung (100) nach Anspruch 4, wobei die elektrisch leitfähige und optisch transparente Schicht (142) elektrisch von der elektrisch leitfähigen Schicht (134) durch dielektrische Abschnitte (140), die zwischen der elektrisch leitfähigen Schicht (134) und der elektrisch leitfähigen und optisch transparenten Schicht (142) angeordnet sind, isoliert ist.

6. Optoelektronische Vorrichtung (100) nach einem der vorhergehenden Ansprüche, wobei die elektrisch leitfähigen Abschnitte (138) elektrisch von der elektrisch leitfähigen Schicht (134) durch wenigstens eine erste dielektrische Schicht (136), die zwischen den elektrisch leitfähigen Abschnitten (138) und der elektrisch leitfähigen Schicht (134) angeordnet ist, isoliert sind.

7. Optoelektronische Vorrichtung (100) nach einem der vorhergehenden Ansprüche, wobei die dritte Elektrode (111) an einem Rand der optoelektronischen Vorrichtung (100) angeordnet ist.

8. Optoelektronische Vorrichtung (100) nach einem der Ansprüche 1 bis 6, wobei:
• jede erste Elektrode (106) zwischen zwei zweiten Elektroden (108) angeordnet ist, mit denen die Abschnitte der elektrisch leitfähigen Schicht (134), die um die Diode (126) angeordnet sind, die den Abschnitt ihrer ersten Halbleiterschicht (120) aufweist, der elektrisch mit der ersten Elektrode (106) gekoppelt ist, elektrisch gekoppelt sind, und
• die optoelektronische Vorrichtung (100) eine Vielzahl von dritten Elektroden (111) aufweist, die jeweils elektrisch mit einem der elektrisch leitfähigen Abschnitte (138) gekoppelt sind und zwischen zwei zweiten Elektroden (108) angeordnet sind, die jeweils elektrisch mit Abschnitten der elektrisch leitfähigen Schicht (134), die um unterschiedliche Dioden (126) angeordnet sind, gekoppelt sind.

9. Optoelektronische Vorrichtung (100) nach einem der Ansprüche 1 bis 6, die eine Vielzahl von dritten Elektroden (111) aufweist, die jeweils elektrisch mit einem der elektrisch leitfähigen Abschnitte (138) gekoppelt sind, wobei jede der ersten Elektroden (106) zwischen einer der zweiten Elektroden (108) und einer der dritten Elektroden (111) angeordnet ist, und wobei jede der dritten Elektroden (111) zwischen einer der ersten Elektroden (106) und einer der zweiten Elektroden (108) angeordnet ist.

10. Optoelektronische Vorrichtung (100) nach einem der vorhergehenden Ansprüche, wobei die Abschnitte der elektrisch leitfähigen Schicht (134), die um wenigstens einen Teil der Dioden (126), die Photodioden entsprechen, angeordnet sind, elektrisch mit den Abschnitten der zweiten Halbleiterschicht (122) der Photodioden gekoppelt sind.

11. Optoelektronische Vorrichtung (100) nach Anspruch 10, wobei die Abschnitte der elektrisch leitfähigen Schicht (134), die um die Photodioden angeordnet sind, elektrisch mit den Abschnitten der zweiten Halbleiterschicht (122) der Photodioden durch wenigstens eine elektrisch leitfähige und optisch transparente Schicht (142), die auf dem Stapel und auf den Abschnitten der elektrisch leitfähigen Schicht (134), die um die Photodioden angeordnet sind, angeordnet ist, gekoppelt sind.

12. Optoelektronische Vorrichtung (100) nach einem der vorhergehenden Ansprüche, die ferner eine Passivierungsschicht (132) aufweist, die zwischen der elektrisch leitfähigen Schicht (134) und dem Stapel angeordnet ist.

13. Verfahren zum Herstellen einer optoelektronischen Vorrichtung (100), das wenigstens die folgenden Schritte aufweist:
• Ausbilden eines Stapels von wenigstens einer ersten und einer zweiten Halbleiterschicht (120, 122), die gemäß entgegengesetzten Leitfähigkeitstypen dotiert sind;
• Erzeugen von Gräben (130), die sich durch den Stapel erstrecken, dabei Dioden (126) voneinander trennen, die jeweils einen Abschnitt des Stapels aufweisen, und die Zugang zu zweiten Elektroden (108) bereitstellen, so dass Bodenwände der Gräben (130) wenigstens teilweise durch die zweiten Elektroden (108) ausgebildet sind, wobei ein Abschnitt der ersten Halbleiterschicht (120) jeder Diode (126) elektrisch mit einer ersten Elektrode (106) gekoppelt ist, die unter dem Abschnitt der ersten Halbleiterschicht (120) angeordnet ist;
• Ausbilden einer elektrisch leitfähigen Schicht (134), die wenigstens gegen Seitenwände der Gräben (130) angeordnet ist, die elektrisch von dem Stapel isoliert ist, die elektrisch mit den zweiten Elektroden (108) gekoppelt ist und die derart unterbrochen ist, dass Abschnitte der elektrisch leitfähigen Schicht (134), die um jede der Dioden (126) angeordnet sind, elektrisch von den Abschnitten der elektrisch leitfähigen Schicht (134), die um die anderen Dioden (126) angeordnet sind, isoliert sind;
• Implementieren von elektrisch leitfähigen Abschnitten (138), die in den Gräben (130) angeordnet sind, die elektrisch von der elektrisch leitfähigen Schicht (134) isoliert sind und die elektrisch miteinander und mit wenigstens einer dritten Elektrode (111) gekoppelt sind.

## Claims

1. Optoelectronic device (100) comprising at least:
- a plurality of diodes (126), each comprising a portion of a stack of at least a first and a second semiconductor layers (120, 122) doped according to opposite conductivity types, a portion of the first semiconductor layer (120) of each diode (126) being electrically coupled to a first electrode (106) arranged under said portion of the first semiconductor layer (120);
- trenches (130) running through the stack, separating the diodes (126) from one another and from which second electrodes (108) are electrically accessible;
- an electrically conductive layer (134) arranged at least against side walls of the trenches (130), electrically insulated from the stack, electrically coupled to the second electrodes (108) and which is interrupted in such a way that portions of the electrically conductive layer (134) arranged around each of the diodes (126) are electrically insulated from other portions of the electrically conductive layer (134) arranged around the other diodes (126);
- electrically conductive portions (138) arranged in the trenches (130), electrically insulated from the electrically conductive layer (134) and electrically coupled to one another and to at least a third electrode (111);
and **characterized in that** bottom walls of the trenches (130) are at least partly formed by the second electrodes (108).

2. Optoelectronic device (100) according to claim 1, wherein the electrically conductive layer (134) is interrupted at bottom walls of the trenches (130).

3. Optoelectronic device (100) according to one of the foregoing claims, wherein the electrically conductive portions (138) are electrically coupled to the portions of the second semiconductor layer (122) of at least part of the diodes (126) corresponding to light-emitting diodes, LEDs.

4. Optoelectronic device (100) according to claim 3, wherein the electrically conductive portions (138) are electrically coupled to the portions of the second semiconductor layer (122) of the LEDs by at least one electrically conductive and optically transparent layer (142) arranged on the stack and on the electrically conductive portions (138).

5. Electronic device (100) according to claim 4, wherein the electrically conductive and optically transparent layer (142) is electrically insulated from the electrically conductive layer (134) by dielectric portions (140) arranged between the electrically conductive layer (134) and the electrically conductive and optically transparent layer (142).

6. Optoelectronic device (100) according to one of the foregoing claims, wherein the electrically conductive portions (138) are electrically insulated from the electrically conductive layer (134) by at least a first dielectric layer (136) arranged between the electrically conductive portions (138) and the electrically conductive layer (134).

7. Optoelectronic device (100) according to one of the foregoing claims, wherein the third electrode (111) is arranged at an edge of the optoelectronic device (100).

8. Optoelectronic device (100) according to one of claims 1 to 6, wherein:
- each first electrode (106) is arranged between two second electrodes (108) to which are electrically coupled the portions of the electrically conductive layer (134) located around the diode (126) having the portion of its first semiconductor layer (120) electrically coupled to said first electrode (106), and
- the optoelectronic device (100) comprises a plurality of third electrodes (111), each electrically coupled to one of the electrically conductive portions (138) and arranged between two second electrodes (108), each electrically coupled to portions of the electrically conductive layer (134) located around different diodes (126).

9. Optoelectronic device (100) according to one of claims 1 to 6, comprising a plurality of third electrodes (111), each electrically coupled to one of the electrically conductive portions (138), each of the first electrodes (106) being arranged between one of the second electrodes (108) and one of the third electrodes (111), and each of the third electrodes (111) is arranged between one of the first electrodes (106) and one of the second electrodes (108).

10. Optoelectronic device (100) according to one of the foregoing claims, wherein the portions of the electrically conductive layer (134) arranged around at least part of the diodes (126) corresponding to photodiodes are electrically coupled to the portions of the second semiconductor layer (122) of the photodiodes.

11. Optoelectronic device (100) according to claim 10, wherein the portions of the electrically conductive layer (134) arranged around the photodiodes are electrically coupled to the portions of the second semiconductor layer (122) of the photodiodes by at least one electrically conductive and optically transparent layer (142) arranged on the stack and on the portions of the electrically conductive layer (134) arranged around the photodiodes.

12. Optoelectronic device (100) according to one of the foregoing claims, further comprising a passivation layer (132) arranged between the electrically conductive layer (134) and the stack.

13. Method of manufacturing an optoelectronic device (100), comprising at least the steps of:
- forming of a stack of at least a first and a second semiconductor layers (120, 122) doped according to opposite conductivity types;
- creation of trenches (130) running through the stack, separating from one another diodes (126), each comprising a portion of the stack and providing access to second electrodes (108) such that bottom walls of the trenches (130) are at least partly formed by the second electrodes (108), a portion of the first semiconductor layer (120) of each diode (126) being electrically coupled to a first electrode (106) arranged under said portion of the first semiconductor layer (120);
- forming of an electrically conductive layer (134) arranged at least against side walls of the trenches (130), electrically insulated from the stack, electrically coupled to the second electrodes (108) and which is interrupted in such a way that portions of the electrically conductive layer (134) arranged around each of the diodes (126) are electrically insulated from the portions of the electrically conductive layer (134) located around the other diodes (126);
- implementation of electrically conductive portions (138) arranged in the trenches (130), electrically insulated from the electrically conductive layer (134) and electrically coupled to one another and to at least a third electrode (111).
